(19) Europäisches Patentamt

European Patent Office

Office européen des brevets

(11) Publication number: **0 551 747 A1**

## (12) EUROPEAN PATENT APPLICATION

(21) Application number: **92311526.5**

(22) Date of filing: **17.12.92**

(51) Int. Cl.⁵: **B32B 15/08**, B32B 7/12, C08J 5/12, //C08L79/08

(30) Priority: **10.01.92 US 820435**

(43) Date of publication of application:
**21.07.93 Bulletin 93/29**

(84) Designated Contracting States:
**DE FR GB IT SE**

(71) Applicant: **GENERAL ELECTRIC COMPANY**
**1 River Road**
**Schenectady, NY 12345(US)**

(72) Inventor: **Minnick, Michael Gerald**
**3517 Amulet Drive**
**Fort Wayne, Indiana 46802(US)**

(74) Representative: **Pratt, Richard Wilson et al**
**London Patent Operation G.E. Technical**
**Services Co. Inc. Essex House 12/13 Essex**
**Street**
**London WC2R 3AA (GB)**

(54) **Polyetherimide flexible films.**

㉗ The present invention is directed to a method for making a composite article wherein metal foil is laminated to a polyetherimide sheet. The method comprises applying an adhesive composition comprising a polyetherimide/amine-terminated dimethylsiloxane copolymer to one side of each of two foils of metal. The adhesive coated side of the metal foil then is mated on opposite sides of the polyetherimide sheet under elevated temperature and pressure for forming the composite article. The polyetherimide is flexible and may be used in forming a flexible circuit board.

EP 0 551 747 A1

## Background of the Invention

The present invention relates to copper-clad polyetherimide flexible films in general and more particularly to adhesive systems used in preparing such films.

Metal-clad printed wiring boards are well known in the art. The simplest of such boards generally comprises a resinous plastic substrate to which is bonded at least one thin sheet of a electrically conductive material, preferably copper. The resinous plastic substrate can be clad with the metal foil on one or both sides, depending upon the desired use, and can be rigid or flexible depending upon the composition of the resinous plastic substrate, the choice of reinforcement (if any), and the intended use of the board.

A variety of substrates have been used in the production of copper-clad laminates for printed wiring boards, including woven fabrics, non-woven fabrics, paper-like materials made from glass fibers, organic fibers, wood pulp, and the like with various thermosetting resins including phenolic resins, epoxy resins, polyester resins, and the like. Specific structures include, for example, paper-phenolic resin, glass mat-polyester, glass cloth-epoxy resin, and like systems. The laminates generally have been produced by impregnating or coating a substrate with a varnish which is liquid at room temperature and has been diluted with a solvent, removing the solvent in a dryer, and simultaneously proceeding the reaction to a state suitable for press molding in a later stage. This produces a so-called "pre-preg" wherein the varnish has proceeded to the B stage. The pre-pregs can be cut to dimension, copper foil placed adjacent one or both surfaces of the pre-preg, and the multi-layer structure sent to pressure molding operations for ultimate cure of the pre-preg and its bonding to the copper foil.

A variety of alternative manufacturing procedures have been proposed in the art. For example, the so-called SMC (sheet molding compound) process utilizes glass chopped strands which are impregnated with an unsaturated polyester resin which has its viscosity chemically increased for handling. A copper foil is affixed to the surface of the impregnated mat and the resulting structure supplied to a heated pressure mold. The pultrusion process for producing a laminate comprises passing a substrate through an unsaturated polyester resin bath for impregnation with the resin, supplying the substrate together with the copper foil into a heating die, and conducting continuous molding. U.S. Pat. No. 4,510,008 proposes coating a solventless thermosetting resin onto one surface of a fibrous substrate, following which copper foil is placed in contact with the coated side of the substrate and the laminate subjected to pressure molding.

In making copper-clad laminates utilizing polyetherimide substrates, optionally reinforced, U.S. Pat. No. 3,682,960 proposes a solvent solution of curable polyamic acid and an amide-modified polyamic acid which is coated on the metal foil and cured. This same type of coating approach for polyetherimides, polyamides, polyimides, and like substrates is proposed in U.S. Pats. Nos. 4,562,119, 4,374,972, and 4,433,131. Adequate peel strengths of the copper foil are reported in these citations. However, when a pre-formed polyetherimide extrudate is placed in contact with copper foil and the laminate sent to a heated press, copper foil peel strengths of the resulting cured laminate are insufficient for a variety of industrial applications.

Copending, commonly-assigned application Serial No. 07/464,819, filed January 16, 1990, discloses an improved process for making copper-clad polyetherimide laminates, directed at improving peel strength, which comprises coating one side of the copper foil with an adhesive composition, placing the coated side of the copper foil in contact with a pre-formed polyetherimide substrate, and heat-pressing the resulting laminate to form a cured laminate of improved peel strength. The adhesive composition utilized comprises a blend of a polyvinyl butyral resin, one or more resole resins, and an organic solvent. Within a temperature range of from about 450° to 500°F. and a pressure range of from about 100 to 700 psi, the adhesively-coated copper foil mated with the pre-formed polyetherimide substrate yields desired peel strengths without inducing excessive flow of the polyetherimide substrate. However, the peel strength achieved is extremely dependent upon the temperature and pressure used during the pressure operation. The temperature cannot be too high or the polyetherimide thermoplastic material will flow too much, resulting in laminates either out of specification with respect to thickness or having thin spots.

## Broad Statement of the Invention

Broadly, the present invention is directed to a method for making a composite article wherein metal foil is laminated to a polyetherimide sheet. The method comprises applying an adhesive composition to one side of each of two foils of metal. The adhesive composition comprises a polyetherimide/amine-terminated dimethylsiloxane copolymer. The adhesive coated side of the metal foil then is mated on opposite sides of the polyetherimide sheet under elevated temperature and pressure for forming the composite article. The polyetherimide sheet advantageously is flexible for use in forming a flexible circuit board.

Advantages of the present invention include good adhesion between the polyetherimide substrate film and the metal (*e.g.* copper) foil as processed and especially after floating on 550°F solder bath for 10 seconds. Another advantage is bonding activation temperatures that are relatively mild which enables the excellent flexibility characteristics of the polyetherimide sheet to be maintained after processing. These and other advantages will be readily apparent to those skilled in the art based upon the disclosure contained herein.

Detailed Description of the Invention

The development of the present invention is an adhesive for bonding copper foil to polyetherimide films for flexible circuitry applications. Desirable performance characteristics therefor include good adhesion between the polyetherimide substrate film and the copper foil, as processed, and after floating at 550°F solder bath for 10 seconds, advantageously bonding activation temperatures and pressures between 100° and 220°C and 25 and 740 psi, maintaining excellent flexibility characteristics of the polyetherimide film substrate after processing, good electrical properties, and compatibility with flexible circuit fabrication presses. Unexpectedly, the use of polyetherimide/dimethylsiloxanecopolymers results in a laminated composite that can maintain 8-10 lb/in peel strength as processed and after 10 second floats on 550°F solder. Such adhesive system provides the advantages of thermoplastic material (extrusion or co-extrusion processing, or for solution casting of films on copper foil, solubility in toluene, excellent flexibility, and long shelf life) combined with the unexpected performance of peel strength retention after solder float.

The polyetherimide/dimethylsiloxane copolymer adhesive can be cast directly on copper foil from, for example, toluene solution, or can be applied by co-extrusion processing. Films ranging from about 0.0003 to 0.001 inch generally will find applicability for bonding copper foil to 0.001 inch to 0.005 inch thick polyetherimide films. Such thin polyetherimide films advantageously are for flexible circuitry applications. The dimethylsiloxane can be incorporated as an ingredient during the polyetherimide formation or a block copolymer of polyetherimide and amine-terminated dimethylsiloxane can he formed. Preferable materials include ULTEM D9000 film which is a block copolymer of polyethermide and amine terminated dimethylsiloxane exhibiting a $T_g$ of 125°-150°C or ULTEM D9001 film which is a copolymer of pre-reacted polyetherimide and an amine-terminated dimethylsiloxane which exhibits a $T_g$ of 80°-150°C (GE Plastics, Pittsfield, MA).

The basic polyetherimides are known in the art and generally are prepared by reacting an organic diamine with an aromatic bis(ether dicarbonyl), *i.e.* an aromatic bis(ether anhydride) or an aromatic bis(ether dicarboxylic acid). Such polyetherimides are shown, for example, in U.S. Patents Nos. 3,803,805, 3,787,364, 3,917,643, and 3,847,867, the disclosures of which are expressly incorporated herein by reference. Such polyetherimides can be used as the flexible core of the laminate, or suitably dimethylsiloxane-modified can he used as the adhesive for bonding copper or like metal foil.

The following examples show in detail how the present invention can be practiced but should in no way be construed as limiting. In this application, all percentages and proportions are by weight and all units are in the metric system, unless otherwise expressly indicated.

EXAMPLES

EXAMPLE 1

Films (0.0003-0.001 in.) of Ultem D9000 and Ultem D9001 polyetherimide/dimethylsiloxane copolymer (General Electric Plastics, Mount Vernon, IN) were cast on the high profile side of 1 oz. JTC copper foil (Gould, Inc.) from 10-15% toluene solutions. Alternate methods of applying the film which also were employed included, *viz*, to paint a film of the solution onto the foil and to apply the film in a continuous fashion using a copper foil treater. The latter method was conducted at a foil speed of 10 ft./min., with the foil being heated in successive 30 ft. oven sections (approximately a 3-minute dwell time).

These foils then were placed on the top and bottom of 0.002" DL4151 Ultem polyetherimide film (General Electric Plastics) and pressed at the temperatures and pressures listed in Table 1 and 2.

## TABLE 1

| Experiment | 1 | 2 |
|---|---|---|
| **Adhesive** | | |
| Type | D9000 | D9001 |
| Thickness (in) | 0.0003 | 0.0003 |
| | | |
| **Lamination** | | |
| Temp. (°C) | 190 | 190 |
| Pressure (psi) | 500 | 500 |
| Time at Temp.(min) | 10 | 10 |
| | | |
| **Peel Strength (IPC Test #1-112)** | | |
| As Received | 9.9 | 5.6 |
| After Solder Float 5 sec. at 500°F | 3.2 | 2.6 |

## TABLE 2

| Experiment | 1 | 2 | 3 |
|---|---|---|---|
| **Adhesive** | | | |
| Type | D9000 | D9000 | D9000 |
| Thickness (in) | 0.0003 | 0.0003 | 0.0003 |
| | | | |
| **Lamination** | | | |
| Temp. (°C) | 230 | 230 | 200 |
| Pressure (psi) | 500 | 100 | 500 |
| Time at Temp.(min) | 5 | 5 | 5 |
| | | | |
| **Peel Strength (IPC Test #1-112)** | | | |
| As Received | 10.2 | 10.8 | 10.4 |
| After Solder Float 10 sec. at 500°F | 2.6 | 8.0 | 9.0 |

Initial comparison of D9000 with D9001 (Table 1) indicates that use of D9000 material resulted in better peel strengths, even though D9001 material exhibited less tendency to curl after one side of the copper was etched. Further processing studies on D9000 material (Table 2) indicates that peel strengths in excess of 8 lbs./in. were achieved, even after exposure to 550°F solder for 10 seconds.

**Claims**

1. A method for making a composite article which comprises the steps of:

(a) applying an adhesive composition to one side of each of two foils of metal, said adhesive composition comprising a polyetherimide/amine-terminated dimethylsiloxane copolymer; and
(b) mating the adhesive coated side of said metal foils on opposite sides of a polyetherimide sheet under elevated temperature and pressure for forming a composite article.

2. The method of Claim 1 wherein said foils comprise copper foil.

3. The method of Claim 1 or Claim 2 wherein said polyetherimide sheet ranges in thickness from about 0.001 and 0.005 inch.

4. The method of any one of Claims 1 to 3 wherein copolymer dissolved in toluene solvent is cast on said foils.

5. The method of any one of Claims 1 to 3 wherein copolymer films between about 0.0003 and 0.001in in thickness are coextruded with said polyetherimide sheet.

6. The method of any one of Claims 1 to 5 wherein said copolymer comprises a block copolymer of polyetherimide and dimethylsiloxane and has a $T_g$ of about $125^0$-$150^0$C.

7. The method of any one of Claims 1 to 5 wherein said copolymer comprises pre-reacted polyetherimide and dimethylsiloxane and has a $T_g$ of about $80^0$-$150^0$C.

8. The method of any preceding claim wherein said coated foils and said polyetherimide are mated at a temperature of between about $100^0$ and $220^0$C and a pressure of between about 25 and 740 psi.

9. The method of Claim 2 wherein said polyetherimide sheet ranges in thickness from about 0.001 and 0.005 inch, said copolymer comprises a block copolymer of polyetherimide and dimethylsiloxane and has a $T_g$ of about $125^0$-$150^0$C, and said coated copper foils and said polyetherimide are mated at a temperature of between about $100^0$ and $220^0$C and a pressure of between about 25 and 740 psi.

European Patent Office

**EUROPEAN SEARCH REPORT**

Application Number

EP 92 31 1526

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-3 740 305 (HOBACK J.T. ET AL)<br>* claims 7,8 *<br>* column 2, line 44 - line 59 *<br>* column 3, line 29 *<br>* column 3, line 34 *<br>* column 4, line 21 *<br>* column 4, line 26 - line 52 *<br>--- | 1,2,8 | B32B15/08<br>B32B7/12<br>C08J5/12<br>//C08L79:08 |
| Y | DATABASE WPIL<br>Derwent Publications Ltd., London, GB;<br>AN 89-018467[03]<br>& JP-A-63 293 050 (MATSUSHITA ELEC WORKS)<br>* abstract *<br>--- | 1,2,8 | |
| Y | US-A-4 389 504 (ST. CLAIR K.A. ET AL)<br>* claims 1,2,4,6 *<br>* column 5, line 37 - line 41 *<br>--- | 1,2,8 | |
| A | EP-A-0 184 937 (HITACHI CHEMICAL CO.)<br>* claims 1,2,7 *<br>* page 10, line 5 - page 11, line 1 *<br>* page 16, line 6 - line 16 *<br>* figures 1,5,6; example 6 *<br>--- | 1,2 | TECHNICAL FIELDS SEARCHED (Int. Cl.5) |
| A | EP-A-0 377 080 (W.L. GORE & ASSOCIATES GMBH)<br>* claims 1-4,16,18,19 *<br>--- | 1 | C08J<br>C08L<br>B32B |
| A | PATENT ABSTRACTS OF JAPAN<br>vol. 14, no. 579 (M-1063)25 December 1990<br>& JP-A-22 51 439 ( SHINKO KAGALU KOGYO KK. ) 9 October 1990<br>* abstract *<br><br>----- | 1 | |

The present search report has been drawn up for all claims

| Place of search | Date of completion of the search | Examiner |
|---|---|---|
| THE HAGUE | 06 MAY 1993 | NIAOUNAKIS M. |